# DEMANDE DE BREVET EUROPEEN

(11) **EP 3 964 306 A1**
(43) Date de publication de la demande: **09.03.2022**
(21) Numéro de dépôt: 21193254.6
(22) Date de dépôt: 26.08.2021
(51) Int. Cl.: B22F 1/00, B22F 3/10, B22F 7/06, C22C 1/04, H01M 4/04, H01M 8/1086

(54) **PROCEDE D'INTERCONNEXION DE COMPOSANTS D'UN SYSTEME ELECTRONIQUE PAR FRITTAGE**

(30) Priorité: 03.09.2020 FR 2008957
(71) Demandeur: Commissariat à l'Energie Atomique et aux Energies Alternatives, 75015 Paris (FR)
(72) Inventeur: FEAUTRIER, Céline, 38054 GRENOBLE Cedex 09 (FR); BRONCHY, Maxime, 38054 GRENOBLE Cedex 09 (FR)
(74) Mandataire: Nony

(57) **Abrégé**

Procédé d'interconnexion de composants d'un système électronique par frittage

Procédé d'interconnexion de composants d'un système électronique, le procédé comportant les étapes de:
a) dépôt d'une solution de frittage sur un premier composant pour former une couche d'interconnexion, la solution de frittage comportant un solvant, des nanoparticules métalliques dispersées dans le solvant, et un agent stabilisant adsorbé sur les nanoparticules métalliques,
les nanoparticules métalliques comportant pour plus de 95,0 %, de préférence pour plus de 99,0 % de leur masse un métal choisi parmi l'argent, l'or, le cuivre et leurs alliages et présentant une forme polyédrique de rapport d'aspect supérieur à 0,8,
b) élimination, au moins partielle, du solvant de la couche d'interconnexion de manière à former au moins un agglomérat dans lequel l'agent stabilisant lie entre elles et maintient à distance les unes des autres au moins une partie des nanoparticules métalliques,
c) déliantage et frittage de la couche d'interconnexion par mise en contact de l'agglomérat avec au moins un agent déstabilisant configuré pour désorber l'agent stabilisant des nanoparticules métalliques afin d'agréger et coalescer lesdites nanoparticules métalliques entre elles, et
d) dépôt d'un deuxième composant au contact de la couche d'interconnexion avant ou au cours du déliantage ou du frittage.

## Description

### Domaine technique

L'invention concerne un procédé d'interconnexion de composants d'un système électronique. Elle concerne en particulier l'interconnexion d'une puce électronique, par exemple faite d'un matériau semi-conducteur avec un substrat diélectrique ou avec un autre composant électronique à haute performance.

### Technique antérieure

L'interconnexion entre les composants d'un système électronique est généralement réalisée au moyen d'une couche métallique dense prise en sandwich entre les composants et au contact de ceux-ci.

Il est connu de longue date de réaliser une telle couche d'interconnexion par brasage, c'est-à-dire par fusion d'un métal ou d'un alliage, généralement à base de plomb ou d'étain, qui après refroidissement forme la couche d'interconnexion. Cependant, les alliages de brasage à base de plomb sont généralement nocifs tandis que les brasures à base d'étain sont moins performantes que les brasures à base de plomb.

Le frittage d'une pâte à fritter à base d'argent est aussi une technique connue pour interconnecter des composants électroniques. Une couche d'interconnexion frittée à base d'argent présente généralement de meilleures propriétés thermiques et électriques qu'une brasure à l'étain. Par exemple, une couche d'interconnexion frittée en argent peut présenter une conductivité électrique supérieure à 20x10⁶ S.m⁻¹ et une conductivité thermique de l'ordre de 200 W.m⁻¹.K⁻¹ alors qu'une couche d'interconnexion brasée à base d'un alliage Sn-Ag-Cu présente une conductivité électrique de 7,5x10⁶ S.m⁻¹ et une conductivité thermique de l'ordre de 50 W.m⁻¹.K⁻¹.

Une telle pâte à fritter comporte généralement au moins 90 % en masse de particules d'argent, un solvant visqueux pour limiter l'étalement de la pâte lors de son dépôt, et non aqueux, pour limiter l'oxydation de l'argent lors du stockage de pâte. Elle peut comporter en outre des additifs pour augmenter la viscosité de la pâte, ainsi qu'un agent stabilisant pour éviter l'agglomération des particules. L'agent stabilisant peut aussi participer à améliorer la cohésion de la couche d'interconnexion.

EP 3 150 301 A1 et US 2019/0283129 A1 décrivent chacun un matériau de collage et une méthode de collage le mettant en œuvre. US 2015/0282330 A1 décrit un adhésif conducteur pour la sérigraphie. EP 3 569 329 A1 décrit une pâte de cuivre pour collage sans pression.

Cependant, le frittage nécessite la mise en œuvre d'un chauffage à une température comprise entre 200°C et 300°C, qui s'avère néfaste pour certains composants électroniques sensibles à la température. Les procédés de frittage connus actuellement ne sont notamment pas adaptés à l'interconnexion d'un composant avec un substrat polymère, d'un composant en un matériau semi-conducteur dopé, dans lequel les porteurs de charge diffusent sous l'effet de la température, ou d'un composant à forte inertie thermique, par exemple un radiateur.

Afin de diminuer la température de frittage, il est connu d'appliquer une pression sur l'assemblage de composants à fritter. Cependant, l'application d'une pression peut endommager les composants.

Un autre moyen connu pour abaisser la température de frittage est de formuler une pâte à fritter comportant des particules micrométriques et des particules nanométriques d'une taille inférieure à 100 nm. De telles particules nanométriques sont plus réactives que les microparticules. Elles frittent entre elles à des températures bien inférieures à la température de fusion de l'argent massif (961 °C). Il est en outre bien connu que la durée nécessaire au frittage diminue de manière non linéaire conjointement avec une diminution de la taille des particules, par exemple selon la loi des similitudes de Herring, comme décrit dans l'article C. Herring, Journal of Applied Physics 21, 301 (1960).

Il est encore connu, par exemple de WO 2019/065221 A1, d'adapter la forme des nanoparticules sous formes de plaquettes à base triangulaire ou hexagonale pour augmenter la surface de contact de la couche d'interconnexion avec les composants à interconnecter. Une pression peut être appliquée sur les composants pour privilégier un agencement à plat des particules et rapprocher les particules.

Il existe donc un besoin pour un procédé de frittage adapté à l'interconnexion de composants d'un système électronique, qui surmonte les inconvénients de l'art antérieur.

### Exposé de l'invention

L'invention concerne un procédé d'interconnexion de composants d'un système électronique, le procédé comportant les étapes de:
a) dépôt d'une solution de frittage sur un premier composant pour former une couche d'interconnexion, la solution de frittage comportant un solvant, des nanoparticules métalliques dispersées dans le solvant, et un agent stabilisant adsorbé sur les nanoparticules métalliques,
   les nanoparticules métalliques comportant pour plus de 95,0 % de leur masse un métal choisi parmi l'argent, l'or, le cuivre et leurs alliages et présentant une forme polyédrique de rapport d'aspect supérieur à 0,8,
b) élimination, au moins partielle, du solvant de la couche d'interconnexion de manière à former au moins un agglomérat dans lequel l'agent stabilisant lie entre elles et maintient à distance les unes des autres au moins une partie des nanoparticules métalliques,
c) déliantage et frittage de la couche d'interconnexion par mise en contact de l'agglomérat avec au moins un agent déstabilisant configuré pour désorber l'agent stabilisant des nanoparticules métalliques afin d'agréger et coalescer lesdites nanoparticules métalliques entre elles, et
d) dépôt d'un deuxième composant au contact de la couche d'interconnexion avant ou au cours du déliantage ou du frittage.

La couche d'interconnexion peut ainsi être aisément frittée à une température inférieure ou égale à 200 °C, et notamment supérieure ou égale à 100°C. Elle peut en outre être frittée sans nécessiter l'application d'une pression.

Des composants d'un système électronique qui sont endommagés sous l'effet d'une trop haute température ou d'une trop forte pression peuvent ainsi être aisément interconnectés en mettant en œuvre le procédé selon l'invention.

### Solution de frittage

Les particules peuvent comporter pour plus de 99,0 %, voire pour plus de 99,9 % de leur masse un métal choisi parmi l'argent, l'or, le cuivre et leurs alliages.

De préférence, plus de 99,0 %, voire plus de 99,9 % de la masse des nanoparticules métallique est constituée par de l'argent. L'argent est préféré car il présente une conductivité électrique et une conductivité thermique supérieures à celles de l'or et du cuivre.

Les nanoparticules métalliques ont une forme polyédrique. Avantageusement les nanoparticules polyédriques présentent au niveau des arêtes entre leurs faces de faibles rayons de courbure. Les arêtes et les sommets d'une nanoparticule polyédrique sont des zones particulièrement réactives qui peuvent être moins recouvertes que les faces par l'agent stabilisant. La coalescence à une température inférieure à 200 °C de nanoparticules métalliques entrant en contact les unes avec les autres est ainsi facilitée. Les arêtes et les sommets ayant de faibles rayons de courbure, leur déstabilisation a lieu à plus basse température. Le phénomène dénommé « *melting point depression »* en anglais décrit la diminution de la température de fusion avec la diminution de la taille des particules. Selon un mécanisme similaire, le frittage de zones présentant un faible rayon de courbure a également lieu à plus basse température.

La forme polyédrique est de préférence convexe. Elle peut être régulière. Elle peut être choisie parmi :
- un hexaèdre, de préférence un cube,
- un octaèdre, et
- un cuboctaèdre.

La forme polyédrique peut être tronquée, *i.e.* obtenue par troncature d'un polyèdre régulier. La troncature d'un polyèdre tronqué consiste en la suppression de portions pyramidales en chaque sommet du polyèdre, les portions pyramidales n'ayant au maximum qu'un sommet en commun.

De préférence, les nanoparticules métalliques sont de forme cubique, optionnellement tronquée.

Les nanoparticules métalliques forment un ensemble particulaire.

Une première fraction de l'ensemble particulaire peut être formée par des nanoparticules métalliques présentant une première forme polyédrique et une deuxième fraction de l'ensemble particulaire peut être formée par des nanoparticules métalliques présentant une deuxième forme polyédrique différente de la première forme polyédrique. La deuxième fraction peut être le complément de la première fraction dans l'ensemble particulaire.

Par ailleurs, les nanoparticules métalliques présentent un rapport d'aspect supérieur à 0,8, de préférence supérieur à 0,9, voire supérieur à 0,95, voire supérieur à 0,99, par exemple égal à 1.

Le « rapport d'aspect » d'une particule est égal au rapport du plus petit axe sur le plus grand axe du plus petit ellipsoïde circonscrit à la particule. Par exemple une particule de forme cubique qui est circonscrite à une sphère présente un rapport d'aspect égal à 1. Le «rapport d'aspect» peut être mesuré à partir d'une image acquise en microscopie électronique à balayage.

La taille de la ou des plus grandes nanoparticules de l'ensemble particulaire est de préférence inférieure à 500 nm.

La « taille » d'une particule est le rayon de la plus petite sphère circonscrite à la particule. Elle peut être mesurée à partir d'une image acquise en microscopie électronique à balayage ou par diffusion dynamique de la lumière.

Les nanoparticules métalliques présentent de préférence une taille moyenne inférieure à 100 nm, de préférence inférieure à 50 nm.

Elles peuvent présenter une taille moyenne comprise entre 1 nm et 30 nm, et notamment d'au moins 5 nm.

La taille « moyenne » d'un ensemble particulaire est la moyenne arithmétique des tailles des particules de l'ensemble particulaire.

L'ensemble particulaire peut être polydisperse ou monodisperse en taille. Au sens de l'invention, un ensemble particulaire monodisperse en taille est tel que l'indice de dispersion en taille, défini comme le rapport de la différence entre le quatre-vingts dixième percentile D₉₀ le dixième percentile D₁₀ des tailles de particules sur la taille médiane D₅₀ des particules, est inférieur à 0,2, de préférence inférieure à 0,1. Notamment, un ensemble particulaire monodisperse en taille peut être tel que les particules qui le composent présentent la même taille.

L'agent stabilisant est adsorbé sur les nanoparticules métalliques. Il maintient les nanoparticules métalliques à distance et empêche leur agglomération au sein de la solution. Il favorise une dispersion homogène des nanoparticules métalliques dans le volume de la solution.

L'agent stabilisant peut être choisi dans le groupe formé par les tensio-actifs anioniques, les tensio-actifs amphotères, les tensio-actifs cationiques, les tensio-actifs non ioniques et leurs mélanges.

L'agent stabilisant peut être choisi parmi la polyvinylpyrrolidone, l'acide polyacrylique, le tricitrate de sodium et leurs mélanges. De préférence, l'agent stabilisant est la polyvinylpyrrolidone, de préférence de masse molaire comprise entre 10 000 g.mol⁻¹ et 300 000 g.mol⁻¹, de préférence égale à 10 000 g.mol⁻¹. La polyvinylpyrrolidone est connue sous l'acronyme PVP.

Le solvant est de préférence organique.

Le solvant peut être choisi parmi l'eau, un polyol et leurs mélanges. En particulier, le solvant peut être un polyol et peut être choisi parmi le 1,2-propanediol, l'éthylène glycol, le diéthylène glycol et leurs mélanges.

Dans un mode de mise en œuvre du procédé, le solvant peut être tel que sa décomposition thermique résulte en la formation de l'agent déstabilisant. De préférence, la température de décomposition thermique du solvant est inférieure à 200°C. Une réaction de déshydratation d'un solvant sous l'effet d'un chauffage est un exemple de décomposition thermique du solvant.

De préférence, selon le premier exemple préféré dans lequel l'agent stabilisant est la PVP, le solvant peut être tel qu'il forme une cétone, optionnellement un aldéhyde, et de l'eau, par exemple par déshydratation sous atmosphère inerte. Une telle cétone, optionnellement mélangée avec de l'eau, est un agent déstabilisant de la PVP. Un solvant décomposable en cétone ou aldéhyde peut être choisi parmi l'éthylène glycol, le diéthylèneglycol, le 1,2-propanediol et leurs mélanges. De préférence, le solvant est le 1,2-propanediol, dont la réaction de déshydratation forme de l'acétone et de l'eau.

La solution de frittage peut être déposée par tout moyen connu, par exemple par sérigraphie, à la seringue, ou par impression.

Le volume de solution de frittage déposé sur le premier composant peut être inférieur à 1000 µl, voire inférieur à 100 µl, par exemple d'environ 15 µl.

La couche d'interconnexion déposée à l'étape a) s'étend de préférence sur une surface d'aire inférieure à 20 mm².

La solution de frittage peut comporter, en pourcentages en masse exprimés sur la base de la masse de la solution de frittage :
- entre 20,0 % et 90,0 % de nanoparticules métalliques polyédriques,
- entre 0,1 % et 3,0 % de l'agent stabilisant, et
- entre 7,0 % et 79,9 % du solvant.

Les nanoparticules métalliques, l'agent stabilisant et le solvant peuvent représenter plus de 95,0 %, de préférence plus de 99,0 %, voire 100 % de la masse de la solution de frittage.

La solution de frittage peut en outre comporter un agent de texture pour augmenter la viscosité de la solution.

La solution de frittage peut comporter un autre ensemble particulaire formé de microparticules métalliques, la plus petite des microparticules présentant une taille supérieure à 1 µm. Les microparticules métalliques sont de préférence formées du même métal ou alliage que les nanoparticules métalliques.

Les microparticules métalliques peuvent présenter une forme différente des nanoparticules métalliques. En particulier, les microparticules métalliques peuvent présenter une forme plaquettaire. Par forme plaquettaire, on considère une forme polyédrique dont le rapport d'aspect est inférieur à 0,7, voire inférieur à 0,5, voire inférieure à 0,3. Les microparticules métalliques augmentent la viscosité de la solution de frittage pour faciliter son dépôt, par exemple par sérigraphie ou par seringue. Ainsi, les microparticules, par leur taille, permettent d'augmenter le volume de la couche d'interconnexion, sans en dégrader les propriétés thermiques, mécaniques et électriques.

La solution de frittage peut comporter, en pourcentages en masse exprimés sur la base de la masse de la solution de frittage :
- entre 0,1 % et 3,0 % de l'agent stabilisant,
- entre 7,0 % et 79,9 % du solvant,
- entre 20,0 % et 90,0 % de nanoparticules métalliques et de microparticules métalliques, le rapport de la teneur en microparticules métalliques sur la somme des teneurs en nanoparticules métalliques et en microparticules métalliques étant compris entre 0,3 et 0,7.

Les nanoparticules métalliques, les microparticules métalliques, l'agent stabilisant et le solvant peuvent représenter plus de 95,0 %, de préférence plus de 99,0 %, voire 100 % de la masse de la solution de frittage.

### Elimination partielle du solvant

A l'étape b), le solvant est, au moins partiellement, éliminé de la couche d'interconnexion.

De préférence, l'élimination du solvant est opérée à une température inférieure à 200 °C.

L'élimination du solvant comporte de préférence l'évaporation et/ou la décomposition, de préférence thermique, du solvant.

Le solvant peut être décomposé thermiquement, optionnellement avant évaporation. Le solvant est alors chauffé à une température supérieure ou égale à sa température de décomposition thermique, notamment sa température de déshydratation. De préférence, la décomposition thermique du solvant est effectuée à une température inférieure ou égale à 200 °C, et de préférence supérieure ou égale à 100 °C et 200 °C.

La décomposition thermique, notamment la déshydratation, du solvant peut résulter en la formation de l'agent déstabilisant. Elle peut en outre s'accompagner de la réaction de l'agent déstabilisant avec le solvant et former un produit de réaction volatile, ce qui facilite l'élimination du solvant. Par exemple, dans la variante où le solvant est le 1,2-propanediol, le chauffage du solvant à une température supérieure à 135 °C entraîne la décomposition du 1,2-propanediol en eau et acétone. L'acétone et l'eau peuvent réagir avec le 1,2-propanediol non décomposé et former du 2,2-triméthyl-dioxolane, qui est sous forme vapeur à une température supérieure à 98 °C et peut donc être extrait aisément de la couche d'interconnexion.

La décomposition thermique du solvant peut être opérée pendant une durée comprise entre 0,5 h et 10 h.

La montée en température du solvant peut être opérée en chauffant le premier composant, le flux de chaleur appliqué au premier composant étant transmis à la couche d'interconnexion. Par exemple, une face inférieure du premier composant peut être chauffée, qui est opposée à la face sur laquelle repose la couche d'interconnexion.

L'évaporation et/ou la décomposition thermique peut être effectuée sous une atmosphère neutre, par exemple sous argon, ou sous une atmosphère réductrice, afin d'éviter l'oxydation des nanoparticules métalliques.

Une partie ou, de préférence, tout le solvant contenu dans la couche d'interconnexion peut être éliminé.

Plus de 95 %, voire plus de 99 %, voire 100 % de la quantité du solvant contenu dans la couche d'interconnexion peut être évaporée.

Au cours de l'élimination du solvant, la concentration en nanoparticules métalliques et en agent stabilisant peut augmenter au sein de la solution de frittage. Il peut en résulter une agglomération des nanoparticules métalliques entre elles. L'agent stabilisant adsorbé sur les nanoparticules agit alors comme un liant entre les nanoparticules. En outre, il maintient les nanoparticules à distance les unes des autres au sein de l'agglomérat ainsi formé.

Les nanoparticules métalliques peuvent former un ou plusieurs agglomérats.

L'agent stabilisant peut former une couche intercalée entre les nanoparticules métalliques et au contact des nanoparticules métalliques, dont l'épaisseur est par exemple comprise entre 1 nm et 10 nm.

### Déliantage et frittage

L'étape c) comporte le déliantage et le frittage de la couche d'interconnexion.

Le déliantage est opéré en mettant en contact l'agglomérat avec un agent déstabilisant.

L'agent déstabilisant interagit avec l'agent stabilisant pour désorber l'agent stabilisant de la surface des nanoparticules métalliques. L'agent déstabilisant permet ainsi d'extraire ou d'éliminer, au moins en partie, l'agent stabilisant hors de l'agglomérat. L'agent stabilisant n'est alors plus intercalé entre les nanoparticules métalliques. Les nanoparticules métalliques tendent alors à entrer en contact, sous l'effet de forces attractives, et forment un agrégat. En outre, du fait de leur faible taille et de leur forme polyédrique, elles présentent une réactivité de surface élevée, notamment auprès des arrêtes et sommets polyédriques, ce qui déclenche leur coalescence et le frittage de l'agrégat.

Connaissant l'agent stabilisant, l'homme du métier sait aisément choisir de manière routinière un tel agent déstabilisant.

L'agent déstabilisant peut notamment être choisi parmi l'eau, une cétone, en particulier l'acétone et/ou la butanone, et leurs mélanges. Une cétone préférée est l'acétone. De préférence, l'agent déstabilisant est différent d'un alcool.

Dans la variante de mise en œuvre où l'agent stabilisant est la PVP, l'agent déstabilisant est de préférence choisi parmi l'acétone, l'eau et leurs mélanges.

L'agent déstabilisant peut être déposé, par exemple sous la forme d'une goutte, sur la couche d'interconnexion.

L'agent déstabilisant peut résulter de la décomposition, de préférence thermique, du solvant. Il peut être formé par au moins un, voire plusieurs des produits issus de la décomposition du solvant et peut-être contenu dans la couche d'interconnexion en fin d'étape b). Ainsi, le contact entre l'agent déstabilisant et l'agent stabilisant à l'étape c) peut être mis en œuvre directement en décomposant, au moins partiellement, le solvant à l'étape b).

Le produit de décomposition peut être formé sous forme vapeur au cours de la décomposition du solvant, puis condenser sur l'agglomérat ou être remis en solution avec le solvant non décomposé au sein de la couche d'interconnexion.

L'étape de déliantage et de frittage est de préférence opérée à une température inférieure à 200 °C, voire inférieure ou égale à 150 °C, et de préférence supérieure ou égale à 100 °C.

Elle peut être opérée à une température inférieure ou égale à 150 °C, par exemple à une température comprise entre 100 °C et 150 °C. Une telle étape peut ainsi être mise en œuvre lorsqu'au moins un des premier et deuxième composants est particulièrement sensible à la température.

Selon une variante, l'étape de déliantage et de frittage peut être mise en œuvre à une température supérieure à 100°C, et par exemple comprise entre 120 °C et 190 °C, afin de densifier et de diminuer la porosité de la couche d'interconnexion, et d'augmenter la tenue mécanique de l'assemblage formé par les premier et deuxième composants et par la couche d'interconnexion.

L'étape de déliantage et de frittage peut être conduite pendant une durée comprise entre 1 h et 10 h.

Par ailleurs, la température à laquelle est conduit le déliantage peut être inférieure à la température à laquelle est conduite le frittage. Le déliantage et le frittage respectivement peuvent être conduits à des températures inférieures et supérieures respectivement à la température d'évaporation de l'agent déstabilisant. Ainsi, au cours du frittage, l'agent déstabilisant résiduel qui n'a pas réagi avec l'agent stabilisant peut être évaporé, de façon à réduire la présence d'éléments organiques résiduels dans la couche d'interconnexion frittée. Par exemple, dans le cas où l'agent déstabilisant est l'acétone, la couche d'interconnexion peut être déliantée à une température inférieure à 56°C, au-delà de laquelle l'acétone est vaporisée, puis frittée à une température supérieure à 56 °C.

La couche d'interconnexion peut être maintenue, et notamment chauffée, à une même température au cours de l'étape b) d'élimination du solvant et de l'étape c) de déliantage et frittage.

A l'étape c) et à l'étape d), le frittage peut être effectué sans application d'une pression, *i.e.* autre que le poids du deuxième composant. Par pression, on entend toute force, autre que le poids du premier composant ou du deuxième composant, appliquée par unité de surface sur la couche d'interconnexion.

Le frittage peut être effectué sans application d'une pression sur la couche d'interconnexion.

En variante, une pression sur la couche d'interconnexion peut être appliquée, qui est de préférence inférieure à 0,1 MPa.

### Dépôt du deuxième composant

Le deuxième composant est déposé sur la couche d'interconnexion au cours du déliantage ou du frittage. Ainsi, la couche d'interconnexion adhère en fin de frittage sur le deuxième composant et connecte ainsi les premier et deuxième composants.

L'épaisseur de la couche d'interconnexion frittée peut être comprise entre 100 nm et 100 µm.

La densité de la couche d'interconnexion frittée est de préférence supérieure à 90 %, de préférence supérieure ou égale à 95 %, voire supérieure à 99 % de la densité dudit métal. La densité de la couche d'interconnexion est mesurée par analyse métallographique après découpe et polissage de la couche d'interconnexion frittée, par exemple par microscopie électronique.

La teneur en espèces résiduelles organiques représente moins de 5 % de la masse de la couche d'interconnexion frittée.

La contrainte de cisaillement à la rupture de l'assemblage formé par la couche d'interconnexion frittée et les premier et deuxième composants est de préférence supérieure à 10 MPa.

La conductivité électrique de la couche d'interconnexion frittée est de préférence supérieure à 5x10⁶ S.m⁻¹. La conductivité thermique de la couche d'interconnexion est de préférence supérieure à 30x10⁶ W.m⁻¹.K⁻¹. Le coefficient d'expansion thermique de la couche d'interconnexion frittée est de préférence inférieur à 30x10⁻⁶ K⁻¹.

Le premier composant et/ou le deuxième composants du système électronique peuvent être choisis parmi un support, notamment flexible et/ou pour l'impression d'un circuit imprimé, une puce en un matériau semi-conducteur, notamment retournée, une diode électroluminescente, notamment de taille inférieure à 10 mm, de préférence inférieure à 5 mm, notamment de taille inférieure à 100 µm, un composant d'un système d'électronique de puissance, par exemple un radiateur thermique.

Au moins l'un des premier et deuxième composants peut présenter une longueur inférieure à 1 mm et/ou une épaisseur inférieure à 500 µm. Le procédé selon l'invention, permettant un frittage à basse température est bien adapté à l'interconnexion de composants de petite taille, qui sont facilement en dommageables sous l'effet d'une température trop élevée. En particulier, l'invention est bien adaptée pour l'interconnexion à petits pas de composants.

Le support peut comporter un substrat diélectrique en un matériau polymère dont la température de fusion est inférieure à 300°C.

En particulier, selon un exemple de mise en œuvre, le premier composant est un support d'impression de circuit imprimé et le deuxième composant est un matériau semi-conducteur.

Le support d'impression de circuit imprimé peut comporter un substrat diélectrique recouvert, au moins partiellement par une couche métallique, notamment en un métal choisi parmi l'argent, l'or, le cuivre et leurs alliages, de préférence en argent ou en or. La solution de frittage peut être déposée sur la couche métallique.

La couche métallique peut être fonctionnalisée afin de réduire la mouillabilité de surface, de minimiser l'étalement de la solution de frittage sur le support, et de faciliter l'agglomération des nanoparticules au cours de l'étape b).

Elle peut être fonctionnalisée au moyen d'une substance choisie parmi un thiol aliphatique, un thiol perfluoré et leurs mélanges. De préférence, elle est fonctionnalisée au moyen d'un thiol aliphatique.

La couche métallique peut être nettoyée, préalablement au dépôt de la solution de frittage, pour supprimer les pollutions organiques naturellement présentes sur la surface de la couche d'or.

Selon un autre exemple de mise en œuvre, au moins l'un des premier et deuxième composants est un radiateur thermique d'un système d'électronique de puissance. Un tel radiateur est ainsi plus facile à interconnecter avec le procédé selon l'invention, qui peut être mis en œuvre à une température inférieure à 200 °C, qu'avec les procédés de l'art antérieur. En effet, il est difficile de chauffer le radiateur à une température supérieure à 200 °C avec les procédés de frittage connus, le temps de montée en température étant long à cause de l'inertie thermique du radiateur. Pour cette raison, avec les procédés de l'art antérieur, les radiateurs sont généralement interconnectés sur un support après l'interconnexion de puces semi-conductrices, dont les propriétés thermiques et mécaniques sont fréquemment dégradées à plus basse température que les radiateurs.

Ainsi, l'invention concerne encore l'interconnexion d'un radiateur d'un système électronique avec un premier composant du système électronique au moyen du procédé selon l'invention, suivie par l'interconnexion d'une puce électronique avec un deuxième composant du système électronique au moyen du procédé selon l'invention. Les premier et deuxième composants peuvent être identiques, par exemple un support d'impression d'un circuit imprimé.

### Autres étapes optionnelles

Le procédé peut comporter, préalablement à l'étape a), la préparation de la solution de frittage.

La préparation de la solution de frittage peut comporter la mise en solution dans le solvant d'un sel comportant le métal formant les nanoparticules métalliques et de l'agent stabilisant, suivie par la germination et la croissance des nanoparticules.

La préparation de la solution de frittage peut en outre comporter un nettoyage des nanoparticules métalliques et une dispersion des nanoparticules dans le solvant.

Par ailleurs, l'invention concerne une solution de frittage comportant un solvant, des nanoparticules métalliques dispersées dans le solvant, et un agent stabilisant adsorbé sur les nanoparticules métalliques,
les nanoparticules métalliques comportant pour plus de 95,0 % de leur masse un métal choisi parmi l'argent, l'or, le cuivre et leurs alliages et présentant une forme polyédrique de rapport d'aspect supérieur à 0,8, la solution de frittage comprenant, en pourcentages en masse :
- entre 20,0 % et 90,0 % de nanoparticules métalliques polyédriques,
- entre 0,1 % et 3,0 % de l'agent stabilisant, et
- entre 7,0 % et 79,9 % du solvant.

La solution de frittage peut notamment comporter une ou plusieurs des caractéristiques optionnelles décrites ci-dessus.

L'invention est illustrée au moyen des exemples qui vont suivre et du dessin qui les accompagnent dans lequel
[Fig 1] la figure 1 représente schématiquement deux exemples de mode de mise en œuvre du procédé selon l'invention,
[Fig 2] la figure 2 est un ensemble photographies en vue de dessus acquises en microscopie électronique à balayage d'une couche d'interconnexion obtenue par un exemple de mise en œuvre du procédé selon l'invention, et
[Fig 3] la figure 3 est une photographie d'une coupe d'une couche d'interconnexion, accompagnée d'une cartographie d'analyse élémentaire obtenue par spectroscopie par diffusion d'énergie.

### Exemples 1 et 2

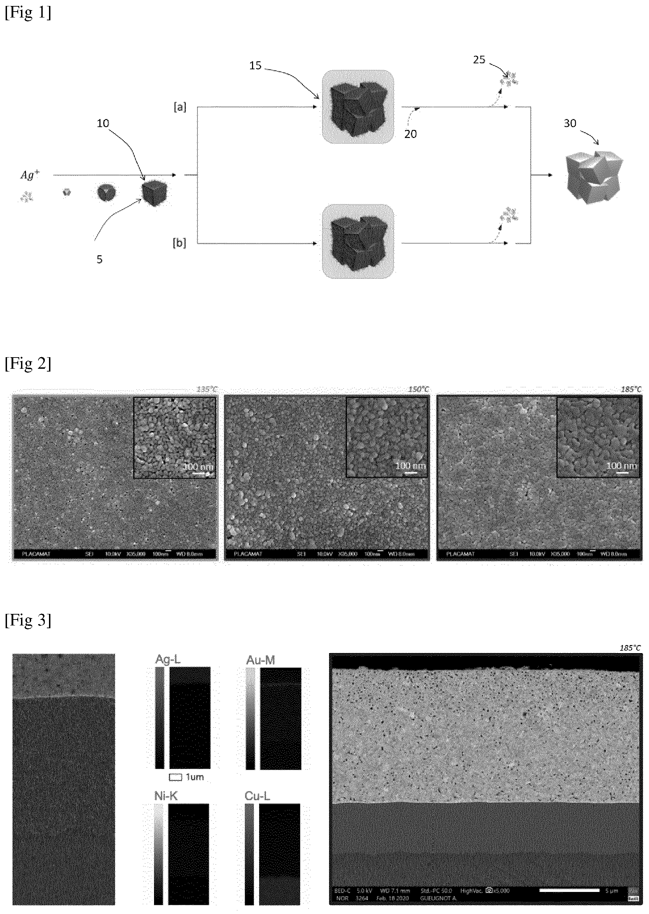

On a illustré à la figure 1 de manière schématique différents exemples de mise en œuvre du procédé selon l'invention.

Préalablement à l'étape a), une solution de base comportant des nanoparticules cubiques d'argent, de taille inférieure à 25 nm, dispersées dans l'éthanol et stabilisées par de la PVP de masse moléculaire 10 000 g.mol⁻¹ a été préparée à partir de sel de nitrate par croissance de nanocubes d'argent en milieu polyol. La méthode décrite dans l'article ACS Appl Mater Interfaces., 2009 September 30; 1(9): 2044-2048., doi:10.1021/am900400, modifiée comme suit, a été mise en œuvre. Un volume de 60 ml d'éthylène glycol a été introduit dans un ballon de 250 ml de contenance et préchauffé à 150°C sous air, puis balayé par un flux d'argon. Après 10 minutes, 0,7 ml d'une solution de NaSH dans de l'éthylène glycol puis 15 ml d'une solution de PVP 10 000 g.mol⁻¹ dans l'éthylène glycol de concentration 40 mg/ml sont successivement introduits dans le ballon. Après 8 minutes d'homogénéisation, un volume de 5 ml d'une solution de nitrate d'argent dans l'éthylène glycol a été introduit dans le ballon. Le milieu réactionnel ainsi formé a été maintenu à 150°C pendant 15 minutes sous agitation magnétique et sous flux d'argon. La réaction de croissance a été ensuite interrompue en immergeant le ballon dans un bain de glace. La dispersion de nanoparticules cubiques d'argent ainsi synthétisée a ensuite été lavée par centrifugation une première fois à l'acétone et plusieurs fois à l'éthanol afin d'éliminer l'excès de réactifs et de PVP du milieu de dispersion, les particules ont ensuite été redispersées dans l'éthanol afin de faciliter leur manipulation et leur conservation. Les nanoparticules de forme cubique protégées par la PVP et dispersées dans l'éthanol ont ensuite été concentrées par évaporation de l'éthanol sous vide. Un volume réduit de 1,2-propandiol a ensuite été ajouté à la dispersion. Le restant d'éthanol a ensuite été évaporé afin de constituer une solution de frittage concentrée en nanoparticules cubiques d'argent, c'est-à-dire comportant au moins 20 % en masse de nanoparticules cubiques d'argent. Cette solution de frittage comporte ainsi, en pourcentages en masse, 22 % de nanoparticules cubiques d'argent 5, 0,7 % de PVP 10 adsorbé sur les nanoparticules et 77,3 % de 1,2-propanediol.

Une goutte d'un volume de 50 µl de solution de frittage a ensuite été déposée sur un substrat diélectrique revêtu d'une couche d'or d'une épaisseur de 30 nm.

Une couche d'interconnexion comportant des agglomérats 15 désordonnés de nanoparticules cubiques liées entre elles par la PVP sont formés sur le substrat diélectrique métallisé or.

A ce stade, plusieurs exemples de mises en œuvre du procédé ont été réalisés pour finalement fritter la couche d'interconnexion en argent.

L'exemple 1 a été mis en œuvre en suivant la voie (a) indiquée sur la figure 1.

Une goutte de 5 µl d'un agent déstabilisant 20, formé en volume de 50 % d'eau et de 50 % d'acétone, a été ensuite déposée sur la couche d'interconnexion à température ambiante, soit 22°C, et sous atmosphère d'argon, afin de désorber le stabilisant organique 25 des nanoparticules et de l'évacuer de l'agglomérat 15.

Un traitement thermique a ensuite été effectué sous atmosphère d'argon. Le traitement thermique était constitué d'un chauffage jusqu'à une température de maintien, d'un maintien à la température de maintien et d'un refroidissement à température ambiante.

Les durées de chauffage et refroidissement ont été fixées à 45 min et 1h pour respectivement l'ensemble des traitements thermiques.

Trois couples de température de maintien et durée de maintien ont été appliqués sur trois échantillons distincts : 135°C pendant 16 h, 150°C pendant 2 h et 185°C pendant 2 h.
Le traitement thermique a permis notamment d'évaporer le 1,2-propanediol, puis de délianter et fritter la couche d'interconnexion. La couche d'interconnexion est frittée lorsque le maintien à la température de maintien a été achevé, les nanoparticules d'argent ayant coalescées entre elles pour former un agrégat fritté 30.

En particulier, une puce électronique peut être déposée sur la couche d'interconnexion avant ou pendant le traitement thermique pour l'interconnecter avec le substrat diélectrique.

L'exemple 2 est mis en œuvre en suivant la voie (b) indiquée sur la figure 1.

Un traitement thermique a ensuite été effectué sous atmosphère d'argon. Le traitement thermique était constitué d'un chauffage jusqu'à une température de maintien, d'un maintien à la température de maintien et d'un refroidissement à température ambiante.

Les durées de chauffage et refroidissement ont été fixées à 45 min et 1h pour respectivement l'ensemble des traitements thermiques.

Trois couples de température de maintien et durée de maintien ont été appliqués sur trois échantillons distincts : 135°C pendant 16 h, 150°C pendant 2 h et 185°C pendant 2 h.

Sous l'effet de la température, le 1,2-propanediol a été évaporé puis décomposé en eau et en acétone pendant l'étape de déliantage durant le chauffage d'une durée de 45 minutes. Un agent déstabilisant de la PVP a ainsi été généré par décomposition du 1,2-propanediol, qui a désorbé la PVP des nanoparticules d'argent. Le déliantage a ainsi été opéré pendant le traitement thermique de la couche d'interconnexion. Le frittage de la couche d'interconnexion a ensuite eu lieu par coalescence des nanoparticules d'argent pendant le maintien à la température de maintien, et formation d'un agrégat fritté 30.

Des photographies acquises en microscopie à balayage en vue de dessus sont représentées sur la figure 2, et une analyse d'une coupe de l'ensemble formé par le substrat et la couche d'interconnexion est représenté sur la figure 3. Comme cela peut être observé, les couches d'interconnexion ainsi obtenues sont frittées et la couche d'interconnexion adhère parfaitement sur le substrat. En outre, aucune diffusion d'or dans la couche d'argent n'est observée. Enfin, la couche d'interconnexion frittée à 185 °C est particulièrement dense et présente une porosité de 5 %.

Après le frittage, une partie de la PVP est restée piégée à l'intérieur de la porosité fermée de l'interconnexion. La quantité de PVP résiduelle est inférieure à 3 % de la masse de la couche d'interconnexion frittée.

L'invention n'est bien évidemment pas limitée aux exemples de mise en œuvre du procédé présentés ci-dessus à titre illustratif.

## Revendications

1. Procédé d'interconnexion de composants d'un système électronique, le procédé comportant les étapes de:
a) dépôt d'une solution de frittage sur un premier composant pour former une couche d'interconnexion, la solution de frittage comportant un solvant, des nanoparticules métalliques dispersées dans le solvant, et un agent stabilisant adsorbé sur les nanoparticules métalliques,
les nanoparticules métalliques comportant pour plus de 95,0 %, de préférence pour plus de 99,0 % de leur masse un métal choisi parmi l'argent, l'or, le cuivre et leurs alliages et présentant une forme polyédrique de rapport d'aspect supérieur à 0,8,
b) élimination, au moins partielle, du solvant de la couche d'interconnexion de manière à former au moins un agglomérat dans lequel l'agent stabilisant lie entre elles et maintient à distance les unes des autres au moins une partie des nanoparticules métalliques,
c) déliantage et frittage de la couche d'interconnexion par mise en contact de l'agglomérat avec au moins un agent déstabilisant configuré pour désorber l'agent stabilisant des nanoparticules métalliques afin d'agréger et coalescer lesdites nanoparticules métalliques entre elles, et
d) dépôt d'un deuxième composant au contact de la couche d'interconnexion avant ou au cours du déliantage ou du frittage.

2. Procédé selon la revendication 1, le solvant étant tel que sa dégradation thermique, notamment sa déshydratation, résulte en la formation de l'agent déstabilisant.

3. Procédé selon la revendication 1 ou 2, plus de 99,0 %, voire plus de 99,9 % de la masse des nanoparticules métalliques étant constituée par de l'argent.

4. Procédé selon l'une quelconque des revendications précédentes, les nanoparticules métalliques étant de forme cubique, optionnellement tronquée.

5. Procédé selon l'une quelconque des revendications précédentes, la solution de frittage comportant, en pourcentages en masse exprimés sur la base de la masse de la solution de frittage :
- entre 20,0 % et 90,0 % de nanoparticules métalliques polyédriques,
- entre 0,1 % et 3,0 % de l'agent stabilisant, et
- entre 7,0 % et 79,9 % du solvant.

6. Procédé selon l'une quelconque des revendications 1 à 4, la solution de frittage comportant un ensemble particulaire formé de microparticules métalliques, la plus petite des microparticules présentant une taille supérieure à 1 µm, la solution de frittage comportant, en pourcentages en masse exprimés sur la base de la masse de la solution de frittage :
- entre 0,1 % et 3,0 % de l'agent stabilisant,
- entre 7,0 % et 79,9 % du solvant,
- entre 20,0 % et 90,0 % de nanoparticules métalliques et de microparticules métalliques, le rapport de la teneur en microparticules métalliques sur la somme des teneurs en nanoparticules métalliques et en microparticules métalliques étant compris entre 0,3 et 0,7.

7. Procédé selon l'une quelconque des revendications précédentes, le solvant étant choisi parmi l'eau, un polyol et leurs mélanges, de préférence le solvant est un polyol choisi parmi le 1,2-propanediol, l'éthylène glycol, le diéthylène glycol et leurs mélanges.

8. Procédé selon l'une quelconque des revendications précédentes, l'agent stabilisant étant choisi parmi les tensio-actifs anioniques, les tensio-actifs amphotères, les tensio-actifs cationiques, les tensio-actifs non ioniques et leurs mélanges, de préférence parmi la polyvinylpyrrolidone, de préférence de masse moléculaire comprise entre 10 000 g.mol⁻¹ et 300 000 g.mol⁻¹, de préférence égale à 10 000 g.mol⁻¹, l'acide polyacrylique, le tricitrate de sodium, et leurs mélanges.

9. Procédé selon l'une quelconque des revendications précédentes, l'agent déstabilisant étant choisi parmi l'eau, une cétone, de préférence l'acétone et leurs mélanges.

10. Procédé selon l'une quelconque des revendications précédentes, l'élimination du solvant à l'étape b) comportant l'évaporation et/ou la décomposition, de préférence thermique, du solvant et/ou l'étape b) d'élimination du solvant étant opérée à une température inférieure à 200 °C.

11. Procédé selon l'une quelconque des revendications précédentes, l'étape c) de déliantage et de frittage étant opérée à une température inférieure à 200 °C, en particulier le frittage étant opéré à une température supérieure ou égale à 100 °C.

12. Procédé selon l'une quelconque des revendications précédentes, dans lequel le premier composant et/ou le deuxième composant du système électronique sont choisis parmi un support, notamment flexible et/ou pour l'impression d'un circuit imprimé, une puce en un matériau semi-conducteur, notamment retournée, une diode électroluminescente, notamment de taille inférieure à 100 µm, un composant d'un système d'électronique de puissance, par exemple un radiateur thermique.

13. Solution de frittage comportant un solvant, des nanoparticules métalliques dispersées dans le solvant, et un agent stabilisant adsorbé sur les nanoparticules métalliques, les nanoparticules métalliques comportant pour plus de 95,0 %, de préférence pour plus de 99,0 % de leur masse un métal choisi parmi l'argent, l'or, le cuivre et leurs alliages et présentant une forme polyédrique de rapport d'aspect supérieur à 0,8, la solution de frittage comportant, en pourcentages en masse exprimés sur la base de la masse de la solution de frittage :
- entre 20,0 % et 90,0 % de nanoparticules métalliques polyédriques,
- entre 0,1 % et 3,0 % de l'agent stabilisant, et
- entre 7,0 % et 79,9 % du solvant.

14. Solution de frittage selon la revendication 13, dans laquelle plus de 95,0 %, voire plus de 99,0 %, voire plus de 99,9 % de la masse des nanoparticules métalliques est constituée par de l'argent.

15. Solution de frittage selon l'une des revendications 13 ou 14, dans laquelle le solvant est choisi parmi l'eau, le 1,2-propanediol, l'éthylène glycol, le diéthylène glycol et leurs mélanges et l'agent stabilisant est choisi parmi les tensio-actifs anioniques, les tensio-actifs amphotères, les tensio-actifs cationiques, les tensio-actifs non ioniques et leurs mélanges, de préférence parmi, la polyvinylpyrrolidone de masse moléculaire comprise entre 10 000 g.mol⁻¹ et 300 000 g.mol⁻¹, idéalement 10 000 g.mol⁻¹, l'acide polyacrylique, le tricitrate de sodium et leurs mélanges.
